# FASCICULE DE BREVET EUROPEEN

(11) **EP 3 455 709 B1**
(45) Date de publication et mention de la délivrance du brevet: **03.06.2020**
(21) Numéro de dépôt: 17723639.5
(22) Date de dépôt: 25.04.2017
(51) Int. Cl.: G06F 3/041, G06F 3/044

(54) **DISPOSITIF D'INTERFACE CAPACITIVE A STRUCTURE D'ELECTRODES MIXTES, ET APPAREIL COMPRENANT LE DISPOSITIF**
KAPAZITIVE SCHNITTSTELLENVORRICHTUNG MIT GEMISCHTER ELEKTRODENSTRUKTUR UND EINRICHTUNG MIT DER VORRICHTUNG
CAPACITIVE INTERFACE DEVICE WITH MIXED ELECTRODE STRUCTURE, AND APPARATUS COMPRISING THE DEVICE

(30) Priorité: 12.05.2016 FR 1654233
(43) Date de publication de la demande: 20.03.2019
(73) Titulaire: Fogale Nanotech, 30900 Nimes (FR)
(72) Inventeur: LEGROS, Eric, 30100 ALES (FR)
(74) Mandataire: IPAZ
(86) Numéro de dépôt international: PCT/EP2017/059823
(87) Numéro de publication internationale: WO 2017/194303

(56) Documents cités:
- US-A1- 2014 253 499
- US-A1- 2014 360 854
- US-A1- 2015 075 959
- US-A1- 2015 160 754

## Description

### Domaine technique

La présente invention concerne un dispositif d'interface capacitive avec une structure d'électrodes mixtes, matricielle et en lignes et colonnes. Elle concerne aussi un appareil comprenant un tel dispositif.

Le domaine de l'invention est plus particulièrement mais de manière non limitative celui des systèmes de mesure capacitifs pour des applications de détection et de contrôle.

### Etat de la technique antérieure

On connaît différentes techniques pour réaliser des dispositifs de détection et de contrôle capacitifs, par exemple pour des applications d'anticollision ou de contrôle de dispositifs industriels. De tels dispositifs comprennent en général des électrodes de détection capacitives qui permettent de détecter des objets d'intérêt par couplage capacitif entre ces objets et les électrodes capacitives. Les électrodes capacitives peuvent être agencées de sorte à recouvrir des surfaces de détection opaques comme des capots d'appareils ou des éléments de robots. Elles peuvent également être superposées à des écrans d'affichage (par exemple de type TFT ou OLED) pour réaliser des interfaces homme-machine.

Les électrodes capacitives peuvent être agencées sous la forme de lignes et de colonnes croisées.

Cette configuration a l'avantage de nécessiter peu d'électrodes, soit au total **L+C** électrodes pour **L** lignes et **C** colonnes.

On peut détecter la présence et la position d'un objet d'intérêt tel qu'un doigt par mesure d'une perturbation des capacités de couplage entre les électrodes en lignes et les électrodes en colonnes, lorsque le doigt approche d'un point d'intersection. Ce mode de mesure est appelé mode mutuel (ou « mutual »).

Ce mode de mesure a toutefois l'inconvénient de manquer de sensibilité, et ne permet pas de détecter des objets à distance de la surface de mesure.

On peut également utiliser une mesure directe des capacités de couplage entre les objets d'intérêt et chaque électrode en ligne ou en colonne. Ce mode de mesure est appelé mode « self ». Il permet de meilleures sensibilités de mesure pour détecter des objets à distance mais présente l'inconvénient majeur de permettre l'apparition de mesures fantômes lorsque plusieurs objets sont présents en regard de différentes lignes ou colonnes.

Les électrodes peuvent être également agencées selon une disposition matricielle.

Dans ce cas, en mettant en œuvre des techniques de mesure directe de capacités de couplage entre les objets d'intérêt et chaque électrode adaptées (mode « self »), on peut obtenir de très grandes sensibilités et ainsi détecter sans ambiguïté plusieurs objets d'intérêt y compris à grande distance des électrodes.

Parmi les techniques en mode « self » qui permettent d'obtenir une sensibilité de mesure importante on connait par exemple :
- les techniques dites « à garde active » dans lesquelles toutes les électrodes et des surfaces de garde à proximité sont polarisées à un même potentiel (le potentiel de garde) pour éviter l'apparition de capacités de couplage parasites. La mesure de capacité s'effectue en général avec un amplificateur de charge.
- les techniques dites à électronique flottante, ou à garde parfaite, dans lesquelles dans lesquelles toutes les électrodes et des surfaces de garde à proximité ainsi que l'électronique de détection sont polarisées ou référencées à un même potentiel (le potentiel de garde), ce qui permet d'éliminer totalement l'apparition de capacités de couplage parasites. Une telle technique est par exemple décrite dans le document US 8,933,710.

La disposition des électrodes sous forme matricielle présente toutefois l'inconvénient de nécessiter un grand nombre d'électrodes de mesure, soit au total **L x** C électrodes pour une matrice de **L** lignes et **C** colonnes.

Pour réaliser des interfaces tactiles et sans contact de grande dimension (par exemple pour réaliser des surfaces sensibles étendues) il est nécessaire de pouvoir :
- détecter sans ambigüité plusieurs objets à grande distance (plusieurs dizaines de centimètres) ; et
- distinguer ou discriminer des objets proches (par exemple 2 doigts) en contact avec la surface de mesure.

Cela peut être réalisé avec des électrodes disposées sous forme matricielle mais un grand nombre d'électrodes est nécessaire ce qui pose des problèmes :
- il faut un grand nombre de voies de mesure et/ou un taux de multiplexage élevé ;
- le nombre et la surface des pistes de liaison qui relient les électrodes de mesure au bord de la surface de détection deviennent importants, ce qui peut poser notamment des problèmes de diaphonie si les objets d'intérêt interagissent avec les pistes. En effet, un couplage capacitif entre un objet d'intérêt et une piste de liaison est interprété comme un couplage capacitif entre cet objet d'intérêt et l'électrode à laquelle cette piste de liaison est reliée, ce qui génère une information de localisation erronée.

On connait également les documents US2014/253499 A1, US2015/160754 A1 et US2015/075959 A1 qui décrivent des dispositifs selon le préambule de la revendication 1.

La présente invention a pour objet de proposer un dispositif d'interface capacitive qui permet de réaliser des surfaces de détection de grande dimension.

La présente invention a également pour objet de proposer un dispositif d'interface capacitive qui permet à la fois de détecter sans ambigüité plusieurs objets à grande distance, et de distinguer ou discriminer des objets proches.

La présente invention a également pour objet de proposer un tel dispositif qui permette d'optimiser le nombre d'électrodes mises en œuvre.

### Exposé de l'invention

Cet objectif est atteint avec un dispositif d'interface capacitive selon la revendication 1.

Suivant des modes de réalisation, le dispositif d'interface selon l'invention peut comprendre :
- Une première électrode capacitive s'étendant selon toute la surface de détection ;
- Une pluralité de premières électrodes capacitives s'étendant selon une première direction ;
- Des premières électrodes capacitives et des secondes électrodes capacitives s'étendant respectivement selon des premières et secondes directions sensiblement perpendiculaires ;
- Des premières électrodes capacitives s'étendant selon des lignes ou sous la forme de lignes, et des secondes électrodes capacitives s'étendant selon des colonnes ou sous la forme de colonnes (ou inversement) ;
- Des premières électrodes capacitives et/ou des secondes électrodes capacitives avec une largeur ou une section constante dans leur direction d'élongation ;
- Des premières électrodes capacitives et/ou des secondes électrodes capacitives avec une largeur ou une section qui présente des variations ou des différences le long de la direction d'élongation, par exemple pour inclure des motifs ou des surfaces spécifiques en certains endroits ;
- Des premières et des secondes électrodes qui sont croisées et superposées ;
- Des premières et/ou des secondes électrodes qui s'étendent depuis un bord de la surface de détection jusqu'à un bord opposé de cette surface de détection ;
- Des premières et/ou des secondes électrodes qui s'étendent depuis un bord de la surface de détection sur une portion de cette surface de détection (par exemple une moitié) ;
- Des premières électrodes réalisées respectivement sous la forme de portions de surfaces interconnectées dans ou en dehors de la surface de détection ;
- Des troisièmes électrodes qui sont insérées entre les secondes électrodes, sur une couche différente ;
- Des troisièmes électrodes qui sont agencées de sorte à laisser libres ou essentiellement libres des zones de croisement ou de superposition entre les premières et les secondes électrodes, dans lesquelles les premières et secondes électrodes sont en regard les unes des autres ;
- Des troisièmes électrodes qui sont agencées selon une disposition matricielle en lignes et en colonnes ;
- des troisièmes électrodes qui sont interconnectées par groupe au niveau de la surface de détection par des portions de pistes de liaison.

Le dispositif selon l'invention peut comprendre des pistes de liaison avec une portion reliant au moins une troisième électrode capacitive à un bord de la surface de détection s'étendant essentiellement selon la seconde direction.

Les pistes de liaison peuvent comprendre des pistes qui s'étendent entre des troisièmes électrodes (ou une troisième électrode reliée à d'autres troisièmes électrodes) et un bord ou la périphérie de la surface de détection, et/ou entre des troisièmes électrodes capacitives voisines.

Ces pistes de liaison peuvent être en partie confondues avec la surface de troisièmes électrodes capacitives, ou en d'autres termes traverser des troisièmes électrodes capacitives qu'elles relient entre elles.

La surface de détection peut être définie comme une surface au-dessus de laquelle des objets d'intérêt peuvent interagir avec les électrodes capacitives et ainsi être détectés. La périphérie (ou zone périphérique) de la surface de détection peut être définie comme une zone en bordure de la surface de détection dans laquelle les pistes et autres composants sont protégés des couplages capacitifs avec des objets d'intérêt, ou du moins pas susceptibles d'être soumis à de tels couplages.

Le dispositif selon l'invention peut notamment comprendre :
- des pistes de liaisons disposées, au moins en partie, ou essentiellement, de manière sensiblement parallèles aux secondes électrodes capacitives ;
- des pistes de liaisons disposées à proximité des secondes électrodes capacitives ;
- des pistes de liaison s'étendant dans la surface de détection entre au moins deux troisièmes électrodes.
- des pistes de liaison s'étendant dans la surface de détection selon la première direction ou la seconde direction entre au moins deux troisièmes électrodes.

Le dispositif selon l'invention peut comprendre des premières électrodes capacitives avec une dimension selon la seconde direction supérieure à l'espace de séparation entre lesdites premières électrodes capacitives.

L'espace de séparation peut être défini comme l'espace qui sépare les bords adjacents de deux premières électrodes capacitives successives.

Le dispositif selon l'invention peut ainsi comprendre des premières électrodes qui sont agencées de sorte à minimiser l'espace qui les sépare. Ainsi, l'ensemble des premières électrodes peut constituer un blindage efficace contre les perturbations électromagnétiques.

Suivant des modes de réalisation, le dispositif selon l'invention peut comprendre des troisièmes électrodes capacitives avec une dimension selon la deuxième direction inférieure ou égale à la dimension de la ou des premières électrodes capacitives selon la ladite deuxième direction, et agencées respectivement en regard d'une première électrode capacitive.

Ainsi, il peut comprendre des troisièmes électrodes qui sont alignées, selon la deuxième direction, avec les premières électrodes, et qui sont superposées aux premières électrodes.

Suivant d'autres modes de réalisation, le dispositif selon l'invention peut comprendre des troisièmes électrodes capacitives avec une dimension selon la deuxième direction inférieure ou égale à la dimension de plusieurs premières électrodes capacitives successives selon la ladite deuxième direction. Dans ces cas, ces troisièmes électrodes capacitives sont agencées respectivement en regard d'un groupe de plusieurs premières électrodes capacitives successives.

Le dispositif selon l'invention comprend :
- une première couche conductrice à l'électricité avec la ou les premières électrodes capacitives,
- une seconde couche conductrice à l'électricité avec les secondes électrodes capacitives,
- une troisième couche conductrice à l'électricité, placée entre la première couche et la seconde couche conductrice à l'électricité, avec les troisièmes électrodes capacitives et les pistes de liaison.

La troisième couche et la première couche sont agencées à l'opposé de la zone de détection des objets d'intérêt par rapport à la seconde couche.

Le dispositif peut comprendre des pistes de liaison au moins en partie disposées sous les secondes électrodes capacitives.

Ainsi, les pistes de liaisons peuvent être au moins en partie masquées par les secondes électrodes capacitives. Cela permet notamment d'éviter des couplages capacitifs parasites entre ces pistes de liaison et des objets d'intérêt, qui peuvent être source de diaphonies.

Pour réaliser des couches opaques, les couches conductrices à l'électricité constituant les électrodes et les pistes de liaison peuvent être réalisées avec des éléments de circuit imprimés multicouches, éventuellement souples.

Pour réaliser des surfaces transparentes, les couches conductrices à l'électricité constituant les électrodes et les pistes de liaison peuvent être réalisées avec des dépôts d'oxydes conducteurs transparents, tels que par exemple de l'ITO (oxyde d'indium-étain), sur un substrat diélectrique.

Les couches constituant les électrodes et les pistes de liaison peuvent également comprendre des structures métalliques à base de nanofils, de type « metal mesh » par exemple, qui sont moins résistives et mieux adaptées à la réalisation de grandes surfaces que l'ITO.

Le substrat diélectrique peut comprendre par exemple du PET (Polytéréphtalate d'éthylène) d'une épaisseur de l'ordre de 25 µm à 100 µm, ou du verre.

Suivant des modes de réalisation, des pistes de liaison reliées respectivement à des troisièmes électrodes capacitives voisines peuvent être en outre reliées électriquement (ou interconnectées) en périphérie ou à l'extérieur de la surface de détection.

Ainsi, le dispositif selon l'invention peut comprendre en outre des moyens électriques d'interconnexion permettant de relier électriquement, en périphérie, dans une zone périphérique ou à l'extérieur de la surface de détection, une pluralité de pistes de liaison reliées respectivement à des troisièmes électrodes capacitives voisines.

Cette interconnexion des pistes de liaisons peut concerner la totalité ou seulement une partie des pistes de liaison.

Le dispositif selon l'invention peut comprendre en outre des moyens électroniques de détection capacitive avec au moins un amplificateur de charge permettant d'effectuer des mesures directes de capacité entre des objets d'intérêt au voisinage ou en contact avec la surface de détection et des groupes de troisièmes électrodes capacitives.

Les moyens électroniques de détection capacitive peuvent comprendre des moyens de scrutation permettant de relier séquentiellement des groupes de troisièmes électrodes capacitives à un amplificateur de charge.

Les moyens électroniques de détection capacitive peuvent être agencés de sorte à polariser la ou les premières électrodes capacitives et les secondes électrodes capacitives à des potentiels sensiblement identiques ou proportionnels à un potentiel de garde, au moins durant des phases de mesures directe de capacité avec les troisièmes électrodes capacitives.

Pour cela, les moyens électroniques de détection capacitive peuvent comprendre des switchs ou des moyens de scrutation permettant de commuter les premières électrodes capacitives et les secondes électrodes capacitives aux potentiels mentionnés.

Ainsi, les premières électrodes capacitives et les secondes électrodes capacitives deviennent des éléments de gardes, c'est-à-dire des éléments destinés à protéger les troisièmes électrodes capacitives des perturbations électromagnétiques et des capacités de couplage parasites, qui sont sources d'erreurs de mesure.

Le potentiel de garde peut comprendre l'un des potentiels suivants :
- un potentiel alternatif ;
- un potentiel continu,
- un potentiel identique, sensiblement identique ou proportionnel à un potentiel de masse.

Le potentiel de masse peut être défini par exemple comme un potentiel de référence général ou de masse général de l'électronique ou de l'appareil. Ce potentiel de masse peut aussi être une terre. Tous les potentiels mentionnés peuvent être définis relativement à ce potentiel de masse.

Suivant des modes de réalisation, le potentiel de garde peut être sensiblement identique ou proportionnel au potentiel électrique des troisièmes électrodes capacitives lorsqu'elles sont utilisées pour les mesures, ou différent. En particulier :
- les troisièmes électrodes capacitives peuvent être polarisées à un potentiel d'excitation alternatif durant les mesures, et le potentiel de garde peut être sensiblement identique ou proportionnel à ce potentiel d'excitation alternatif ; ou
- les troisièmes électrodes capacitives peuvent être polarisées à un potentiel d'excitation alternatif durant les mesures, et le potentiel de garde peut être continu, identique, sensiblement identique ou proportionnel au potentiel de masse.

Suivant des modes de réalisation, le dispositif selon l'invention peut comprendre en outre des moyens électroniques de détection capacitive avec au moins un amplificateur de charge permettant d'effectuer des mesures directes de capacité entre des objets d'intérêt au voisinage ou en contact avec la surface de détection et, respectivement, une ou des premières électrodes capacitives et des secondes électrodes capacitives.

Suivant des modes de réalisation, le dispositif selon l'invention peut comprendre en outre des moyens électroniques de détection capacitive permettant d'effectuer des mesures de variations de capacité de couplage entre une ou des premières électrodes capacitives et des secondes électrodes capacitives, de sorte à détecter la présence d'objets d'intérêt au voisinage ou en contact avec la surface de détection.

Le dispositif selon l'invention peut comprendre des moyens électroniques de détection capacitive agencés de sorte à polariser au moins une première, respectivement une seconde électrode capacitive avec un potentiel d'excitation, et à effectuer une mesure de capacité de couplage sur au moins une seconde, respectivement une première électrode capacitive.

Suivant des modes de réalisation, le potentiel d'excitation peut comprendre l'un des potentiels suivants :
- un potentiel alternatif ;
- un potentiel sensiblement identique ou proportionnel au potentiel de garde.

Suivant des modes de réalisation, les moyens de détection électroniques peuvent être agencés de sorte à maintenir les troisièmes électrodes capacitives, au moins durant des phases de mesure de capacités de couplage, dans l'un des états suivants :
- polarisées à un potentiel continu ;
- polarisées à un potentiel sensiblement identique à un potentiel de masse ;
- polarisées à un potentiel sensiblement identique au potentiel d'au moins une première électrode capacitive ;
- polarisées à un potentiel sensiblement identique au potentiel d'au moins une seconde électrode capacitive ;
- flottantes électriquement.

Cette polarisation des troisièmes électrodes peut être réalisée par exemple au moyen de switchs. De même, les troisièmes électrodes peuvent être électriquement isolées ou déconnectées pour être rendues flottantes au moyen de switchs.

Suivant un autre aspect, il est proposé un appareil comprenant un dispositif d'interface capacitive selon l'invention.

L'appareil peut comprendre par exemple un dispositif d'imagerie médical tel qu'un scanner ou un bras de robot. Il peut comprendre un dispositif d'interface capacitive équipant des parois d'éléments mobiles et destiné à détecter des objets ou des parties de corps humain dans leur voisinage, pour des applications d'anticollision ou de positionnement précis.

Le dispositif d'interface capacitive peut également être mis en œuvre pour des applications de contrôle, tactile et/ou sans contact, pour interagir avec l'appareil.

L'appareil selon l'invention peut notamment comprendre un dispositif d'interface capacitive superposé ou intégré à un dispositif d'affichage.

Le dispositif d'affichage peut notamment comprendre un écran de type TFT ou OLED, tel que par exemple un moniteur de grande dimension pour des applications médicales ou industrielles.

Le dispositif d'interface capacitive selon l'invention est ainsi particulièrement adapté à la réalisation d'interfaces de détection et/ou de contrôle tactile de grande taille, en particulier pour des applications professionnelles.

Il peut être par exemple réalisé sous la forme d'une peau sensible ou d'une surface sensible, pour la réalisation d'une interface homme machine ou pour des applications de détection ou de contrôle d'environnement, par exemple pour des applications en robotique.

Le dispositif d'interface selon l'invention comprend une superposition :
- d'une structure d'électrodes croisées, par exemple en lignes et colonnes, constituée par la ou les premières électrodes et les secondes électrodes ; et
- d'une structure d'électrodes matricielles avec les troisièmes électrodes.

La structure d'électrodes croisées des premières et secondes électrodes constitue un maillage dont le pas est déterminé dans les premières et secondes directions par la distance séparant le centre ou la ligne médiane de deux électrodes successives.

Ce pas détermine la résolution spatiale ou l'écartement minimal nécessaire entre deux objets d'intérêt pour qu'ils puissent être distinguées ou discriminés par les premières et les secondes électrodes.

Cette structure d'électrodes croisée est plus particulièrement utilisée pour détecter des objets d'intérêt en contact avec, ou à proximité immédiate de la surface de détection. Sa sensibilité aux objets d'intérêt à distance peut être limitée.

Les troisièmes électrodes matricielles sont insérées dans la structure d'électrodes croisées constituée par les premières électrodes et des secondes électrodes. Ces troisièmes électrodes sont reliées entre elles par des pistes de liaison pour constituer une structure matricielle de groupes de troisièmes électrodes ou de macro-électrodes de taille plus importante, ce qui permet d'augmenter leur portée de détection et de limiter le nombre de pistes de liaisons vers la périphérie de la zone de détection.

Cette structure matricielle de macro-électrodes est plus particulièrement utilisée pour détecter des objets d'intérêts à distance de la surface de détection. Bien entendu, sa résolution spatiale est dégradée par rapport à celle de la structure d'électrodes croisées, mais ce n'est pas gênant dans la mesure où de toute façon la résolution spatiale minimale atteignable physiquement se dégrade avec l'éloignement des objets d'intérêt du fait de l'étalement des lignes de champ électrique.

Cette disposition en double structure présente l'avantage de permettre de réduire considérablement le nombre de pistes de liaisons qui doivent traverser la surface de détection, ainsi que le nombre de voies de mesure, tout en préservant à la fois :
- la résolution spatiale pour les mesures sur des objets d'intérêts en contact avec, ou à proximité immédiate de la surface de détection, et
- la capacité à détecter une pluralité d'objets d'intérêts à distance de la surface de détection.

La réduction du nombre de pistes de liaison a un double intérêt :
- la surface disponible pour des électrodes augmente,
- les couplages parasites entre les objets d'intérêts et les pistes de liaison diminuent.

Ces avantages sont particulièrement importants pour la réalisation d'écrans ou de surfaces sensibles de grande taille.

Par exemple, l'invention permet de remplacer tout en maintenant des performances de mesure comparables une structure matricielle de **L** lignes et **C** colonnes, soit **L x C** électrodes avec donc **L x C** pistes de liaisons qui doivent traverser la surface sensible pour être reliées à une électronique de détection, par :
- **L + C** électrodes en lignes et colonnes qui ne nécessitent pas de pistes de liaison lorsqu'elles s'étendent jusqu'à un bord au moins de la surface sensible, et
- **(L x C)/g** macro-électrodes et pistes de liaison, avec **g** étant le nombre total d'électrodes dans chaque groupe de troisièmes électrodes.

Par exemple, si on regroupe les troisièmes électrodes par groupe de quatre dans la première et la seconde direction (soit seize électrodes au total), le nombre total de pistes de liaisons peut être réduit d'un facteur seize.

### Description des figures et modes de réalisation

D'autres avantages et particularités de l'invention apparaîtront à la lecture de la description détaillée de mises en œuvre et de modes de réalisation nullement limitatifs, et des dessins annexés suivants :
- la Fig. 1 illustre une vue de profil de dispositif selon l'invention avec une structure à trois couches,
- la Fig. 2 illustre un premier mode de réalisation de dispositif selon l'invention,
- la Fig. 3 illustre un second mode de réalisation de dispositif selon l'invention,
- la Fig. 4 illustre une vue de profil de dispositif qui ne fait pas partie de l'invention revendiquée dans les revendications avec une structure à deux couches,
- la Fig. 5 illustre un troisième mode de réalisation de dispositif qui ne fait pas partie de l'invention revendiquée dans les revendications,
- la Fig. 6 illustre un schéma d'électronique capacitive pour effectuer des mesures directes de capacité en mode « self » qui met en œuvre une garde active,
- la Fig. 7 illustre un schéma d'électronique capacitive pour effectuer des mesures directes de capacité en mode « self » qui met en œuvre une garde active et une électronique référencée au potentiel de garde,
- la Fig. 8 illustre un schéma d'électronique capacitive pour effectuer des mesures de capacités de couplage, en mode « mutual ».

Il est bien entendu que les modes de réalisation qui seront décrits dans la suite ne sont nullement limitatifs.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

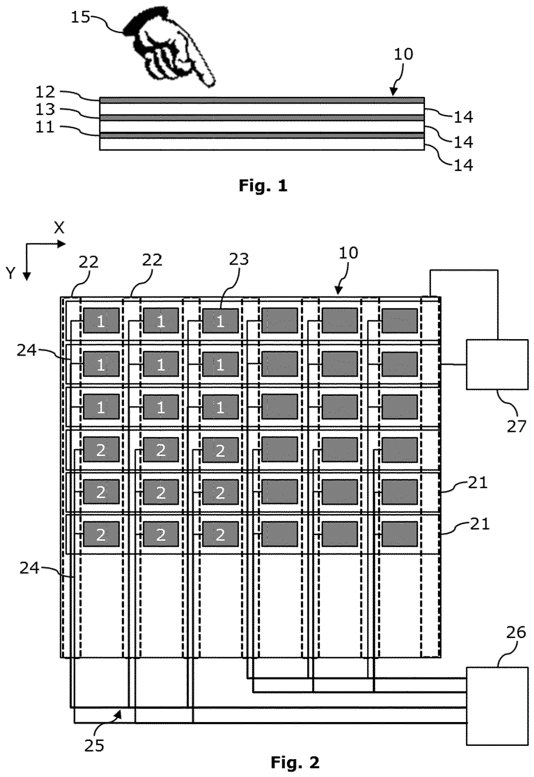

On va décrire, en référence aux Fig. 1 et Fig. 2, un premier mode de réalisation de dispositif d'interface capacitive selon l'invention.

Le dispositif d'interface comprend une surface de détection 10 qui est réalisée sous la forme d'un panel de détection multicouche avec les électrodes capacitives. Plus précisément, cette surface de détection 10 peut être définie comme la surface au-dessus de laquelle un objet d'intérêt 15 (tel qu'un doigt ou une autre partie du corps) peut interagir avec les électrodes capacitives et ainsi être détecté. Ainsi un objet d'intérêt peut être détecté lorsqu'il est en contact avec la surface de détection 10 (détection de contact) ou dans une zone de détection en regard de cette surface de détection 10 (détection de proximité ou de survol).

Le panel constituant la surface de détection 10 comprend une pluralité de couches conductrices 11, 12, 13 pour réaliser les électrodes et les pistes de liaison déposées sur des couches de substrat diélectrique 14.

Ce panel peut être réalisé de différentes manières.

Pour réaliser des surfaces opaques, il peut être réalisé avec du circuit imprimé multicouche classique (PCB), avec des couches conductrices 11, 12, 13 de métal intercalée avec des couches de substrat diélectrique 14. Pour pouvoir être conformé à une surface particulière, il peut être réalisé avec un circuit imprimé souple, avec un substrat diélectrique 14 de type polyimide par exemple.

Le panel constituant la surface de détection 10 peut également être réalisé de sorte à être sensiblement transparent, pour pouvoir être superposé par exemple à une vitre, un miroir ou écran d'affichage, de type TFT ou OLED par exemple.

Dans ce cas, le substrat diélectrique peut être par exemple du PET (Polytéréphtalate d'éthylène) d'une épaisseur de l'ordre de 25 µm à 100 µm, ou du verre.

Les couches conductrices constituant les électrodes et les pistes de liaison sont réalisées avec des dépôts d'ITO (oxyde d'indium-étain). Elles peuvent également comprendre des structures métalliques à base de nanofils, de type « metal mesh » par exemple, pour réaliser les pistes de liaison et/ou les électrodes.

La surface de détection 10, ou le panel de détection, comprend deux structures d'électrodes mêlées : une structure d'électrodes en lignes et colonnes et une structure d'électrodes matricielle.

La structure d'électrodes en lignes et colonnes est destinée à détecter plus particulièrement les objets d'intérêt 15 à proximité immédiate de la surface de détection 10 ou en contact avec cette surface.

Elle comprend des premières électrodes capacitives 21 qui s'étendent selon une première direction X, en ligne donc dans le mode de réalisation de la Fig. 2. Ces premières électrodes 21 sont réalisées dans une première couche 11 de matériau conducteur, qui est aussi la couche la plus éloignée de la zone de détection des objets d'intérêt 15. Ces premières électrodes 21 sont réalisées sous la forme de bandes dont la largeur est proche du pas entre deux électrodes successives, avec un espace minimal entre elles. Ainsi elles couvrent la quasi-totalité de la surface de la première couche 11 de matériau conducteur, de sorte à constituer une protection efficace contre les perturbations électromagnétiques issues de l'électronique sous-jacente, telle que par exemple l'écran d'affichage sur lequel le panel est fixé. Dans le mode de réalisation présenté, les premières électrodes 21 s'étendent d'un bord à l'autre de la surface de détection 10 dans la première direction X.

La structure d'électrodes en lignes et colonnes comprend également des secondes électrodes capacitives 22 qui s'étendent selon une seconde direction Y, en colonne donc dans le mode de réalisation de la Fig. 2. Ces secondes électrodes 22 sont réalisées dans une seconde couche 12 de matériau conducteur, qui est aussi la couche la plus proche de la zone de détection des objets d'intérêt 15. Elles sont de largeur sensiblement inférieure à la largeur des premières électrodes 21, et disposées de manière espacée.

Les secondes électrodes capacitives 22 sont donc superposées aux premières électrodes capacitives 21. Les premières électrodes 21 et les secondes électrodes 22 constituent un maillage dont le pas dans les directions X et Y est ajusté pour permettre de distinguer des objets d'intérêt 15 proches les uns des autres. Cette capacité de séparation ou « pinch » est précisément déterminée par le pas des électrodes.

Les premières électrodes 21 et les secondes électrodes 22 sont reliées à une électronique de détection capacitive en lignes-colonnes 27.

La structure d'électrodes matricielles comprend des troisièmes électrodes 23 réparties selon une disposition matricielle de même pas que le maillage des premières électrodes 21 et les secondes électrodes 22.

Ces troisièmes électrodes 23 sont réalisées sur une troisième couche conductrice 13 placée entre la couche conductrice 11 des premières électrodes et la couche conductrice 12 des secondes électrodes 22. Elles sont positionnées, selon la première direction X, entre les secondes électrodes 22, avec une dimension selon cette première direction X inférieure à l'espace entre les secondes électrodes successives 22, de sorte qu'il n'y ait pas de recouvrement entre ces troisièmes électrodes 23 et les secondes électrodes 22. Les troisièmes électrodes 23 sont en outre positionnées selon la seconde direction Y en regard des premières électrodes 21, avec une dimension selon cette seconde direction Y inférieure à la largeur des premières électrodes 21. Ainsi, les troisièmes électrodes 23 sont agencées de sorte à laisser suffisamment d'espaces libres pour permettre des interactions électriques entre les premières électrodes 21, les secondes électrodes 22 et les objets d'intérêt 15. En outre, chaque troisième électrode 23 est protégée des perturbations électromagnétiques et des couplages capacitifs parasites par la première électrode 21 au-dessus de laquelle elle est positionnée.

Les troisièmes électrodes 23 sont reliées à la périphérie de la surface de détection 10 par des pistes de liaison 24 qui sont réalisées dans la même troisième couche conductrice 13 que ces électrodes.

Chaque piste de liaison 24 est reliée, dans la surface de détection 10, à plusieurs troisièmes électrodes 23 successives. Dans le mode de réalisation présenté, chaque piste de liaison 24 est ainsi reliée à trois troisièmes électrodes 23 successives selon la seconde direction Y. Bien entendu, il s'agit d'un exemple non limitatif et en pratique chaque piste de liaison 24 peut être reliée à un nombre quelconque de troisièmes électrodes 23.

Les troisièmes électrodes 23 ainsi reliées à une piste de liaison 24 se comportent comme une électrode unique, ou macro-électrode, d'une dimension correspondant sensiblement à la surface couverte par l'ensemble des troisièmes électrodes 23 interconnectées. De préférence, on relie des troisièmes électrodes voisines de sorte à former des macro-électrodes avec une surface connexe.

Les pistes de liaisons 24 s'étendent pour l'essentiel selon la seconde direction Y. Elles sont placées sous une seconde électrode 22 ce qui permet de les protéger des interactions avec les objets d'intérêt 15, sources de distorsions et de diaphonie.

Chaque piste de liaison 24 issue de la surface de détection 10 peut être reliée directement à une électronique de détection capacitive matricielle 26.

Dans le mode de réalisation présenté, les pistes de liaison 24 issues de troisièmes électrodes 23 adjacentes dans la première direction X (par exemple 3 colonnes adjacentes) sont reliées électriquement ou interconnectées dans une zone en périphérie, ou zone périphérique 25 de la surface de détection.

On réalise ainsi une matrice de macro-électrodes dont le pas dans les deux directions X et Y est comparable. Deux exemples de telles macro-électrodes 1, 2 sont représentées dans la Fig. 2. Seules les pistes de liaison 24 ainsi regroupées sont reliées à l'électronique de détection capacitive matricielle 26.

Il est également possible de n'interconnecter dans la zone périphérique 25 qu'une partie des pistes de liaison issues de colonnes adjacentes, de sorte à réaliser des macro-électrodes 1,2 de taille différente en fonction de leur position dans la surface de détection 10. On peut par exemple réaliser ainsi une matrice de macro-électrodes 1,2 dont le pas dans les deux directions X et Y est comparable, sauf en bordure de la zone de détection 10, où le pas dans la direction X correspond à celui des colonnes.

L'électronique de détection capacitive en lignes-colonnes 27 et l'électronique de détection capacitive matricielle 26 peuvent bien entendu être réalisées sous la forme d'une même électronique ou d'un même circuit électronique.

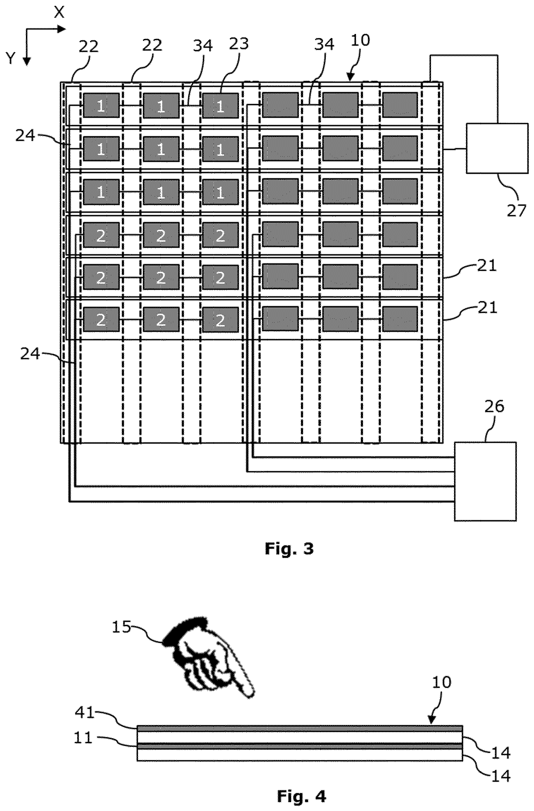

En référence à la Fig. 3, on va maintenant décrire un second mode de réalisation de dispositif selon l'invention.

Sauf mention contraire, tout ce qui a été décrit en relation avec les modes de réalisation illustré aux Fig. 1 et Fig. 2 est applicable à ce mode de réalisation. Aussi seules les différences seront détaillées.

De même que précédemment, la surface de détection 10, ou le panel de détection, comprend deux structures d'électrodes mêlées : une structure d'électrodes en lignes et colonnes et une structure d'électrodes matricielle.

La structure d'électrodes en lignes et colonnes comprend des premières électrodes capacitives 21 qui s'étendent selon une première direction X. Ces premières électrodes 21 sont réalisées dans une première couche 11 de matériau conducteur, qui est aussi la couche la plus éloignée de la zone de détection des objets d'intérêt 15. Ces premières électrodes 21 sont réalisées sous la forme de bandes dont la largeur est proche du pas entre deux électrodes successives, avec un espace minimal entre elles.

La structure d'électrodes en lignes et colonnes comprend également des secondes électrodes capacitives 22 qui s'étendent selon une seconde direction Y. Ces secondes électrodes 22 sont réalisées dans une seconde couche 12 de matériau conducteur, qui est aussi la couche la plus proche de la zone de détection des objets d'intérêt 15. Elles sont de largeur sensiblement inférieure à la largeur des premières électrodes 21, et disposées de manière espacée.

Les premières électrodes 21 et les secondes électrodes 22 sont reliées à une électronique de détection capacitive en lignes-colonnes 27.

La structure d'électrodes matricielles comprend des troisièmes électrodes 23 réparties selon une disposition matricielle de même pas que le maillage des premières électrodes 21 et les secondes électrodes 22.

Ces troisièmes électrodes 23 sont réalisées sur une troisième couche conductrice 13 placée entre la couche conductrice 11 des premières électrodes et la couche conductrice 12 des secondes électrodes 22. Elles sont positionnées, selon la première direction X, entre les secondes électrodes 22, avec une dimension selon cette première direction X inférieure à l'espace entre les secondes électrodes successives 22, de sorte qu'il n'y ait pas de recouvrement entre ces troisièmes électrodes 23 et les secondes électrodes 22. Les troisièmes électrodes 23 sont en outre positionnées selon la seconde direction Y en regard des premières électrodes 21, avec une dimension selon cette seconde direction Y inférieure à la largeur des premières électrodes 21.

Les troisièmes électrodes 23 sont reliées à la périphérie de la surface de détection 10 par des pistes de liaison 24 qui sont réalisées dans la même troisième couche conductrice 13 que ces électrodes.

Chaque piste de liaison 24 est reliée, dans la surface de détection 10, à plusieurs troisièmes électrodes 23 successives. Dans le mode de réalisation présenté, chaque piste de liaison 24 est ainsi reliée à trois troisièmes électrodes 23 successives selon la seconde direction Y. Bien entendu, il s'agit d'un exemple non limitatif et en pratique chaque piste de liaison 24 peut être reliée à un nombre quelconque de troisièmes électrodes 23.

Dans ce mode de réalisation, la surface sensible 10 comprend également des pistes de liaison inter-électrodes 34 qui permettent de relier des troisièmes électrodes 23 successives ou voisines selon la première direction X. Ces pistes de liaison inter-électrodes 34 sont réalisées dans la même troisième couche conductrice 13 que les troisièmes électrodes 23 et les pistes de liaison 24. Dans le mode de réalisation présenté, trois troisièmes électrodes 23 successives sont ainsi reliées selon la première direction X. Bien entendu, il s'agit d'un exemple non limitatif et en pratique un nombre quelconque de troisièmes électrodes 23 peuvent ainsi être reliées.

Des macro-électrodes 1, 2 sont ainsi directement réalisées au niveau de la surface sensible 10. Dans le mode de réalisation présenté et à titre d'exemple, ces macro-électrodes comprennent neuf troisièmes électrodes 23.

Ce mode de réalisation a l'avantage de nécessiter moins de pistes de liaison 24, puisqu'une seule piste de liaison 24 est nécessaire pour chaque macro-électrode.

Les pistes de liaisons 24 issues des macro-électrodes 1, 2 s'étendent pour l'essentiel selon la seconde direction Y. Elles sont placées sous une seconde électrode 22 ce qui permet de les protéger des interactions avec les objets d'intérêt 15, sources de distorsions et de diaphonie.

Les pistes de liaison 24 issue de la surface de détection 10 sont ensuite reliées à une électronique de détection capacitive matricielle 26.

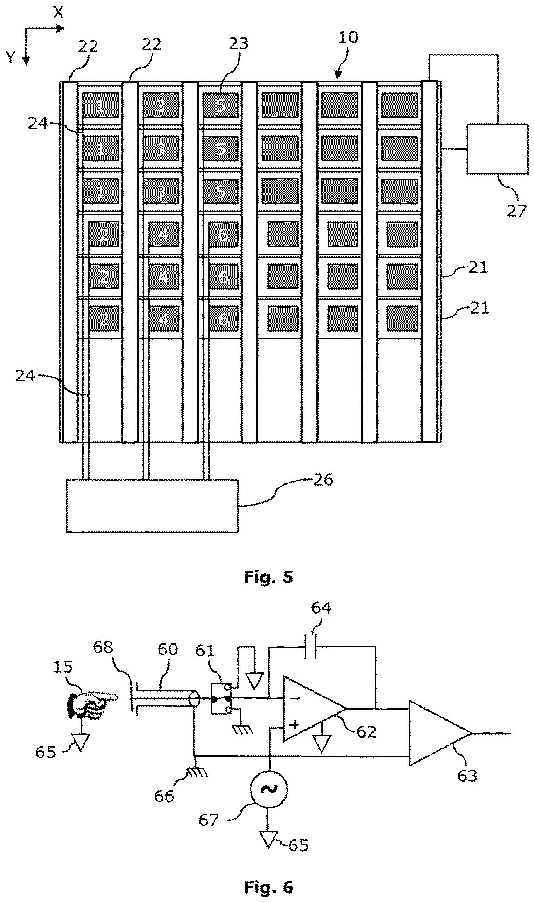

En référence aux Fig. 4 et Fig. 5, on va maintenant décrire un troisième mode de réalisation de dispositif selon l'invention qui ne fait pas partie de l'invention revendiquée dans les revendications.

Sauf mention contraire, tout ce qui a été décrit en particulier en relation avec les Fig. 1 et Fig. 2 est applicable à ce mode de réalisation. Aussi seules les différences seront détaillées.

Ce mode de réalisation diffère essentiellement de celui décrit en relation avec les Fig. 1 et 2 en ce que les pistes de liaison et les électrodes sont réalisées dans deux couches conductrices 11, 41 déposées sur des couches de substrat diélectriques 14.

De même que précédemment, la surface de détection 10, ou le panel de détection, comprend deux structures d'électrodes mêlées : une structure d'électrodes en lignes et colonnes et une structure d'électrodes matricielle.

La structure d'électrodes en lignes et colonnes comprend des premières électrodes capacitives 21 qui s'étendent selon une première direction X. Ces premières électrodes 21 sont réalisées dans une première couche 11 de matériau conducteur, qui est aussi la couche la plus éloignée de la zone de détection des objets d'intérêt 15. Ces premières électrodes 21 sont réalisées sous la forme de bandes dont la largeur est proche du pas entre deux électrodes successives, avec un espace minimal entre elles.

La structure d'électrodes en lignes et colonnes comprend également des secondes électrodes capacitives 22 qui s'étendent selon une seconde direction Y. Ces secondes électrodes 22 sont réalisées dans une seconde couche 41 de matériau conducteur, qui est aussi la couche la plus proche de la zone de détection des objets d'intérêt 15. Elles sont de largeur sensiblement inférieure à la largeur des premières électrodes 21, et disposées de manière espacée.

Les premières électrodes 21 et les secondes électrodes 22 sont reliées à une électronique de détection capacitive en lignes-colonnes 27.

La structure d'électrodes matricielles comprend des troisièmes électrodes 23 réparties selon une disposition matricielle de même pas que le maillage des premières électrodes 21 et les secondes électrodes 22.

Ces troisièmes électrodes 23 sont réalisées sur la seconde couche 41 qui comprend les secondes électrodes 22. Elles sont positionnées, selon la première direction X, entre les secondes électrodes 22, avec une dimension selon cette première direction X inférieure à l'espace entre les secondes électrodes successives 22. Les troisièmes électrodes 23 sont en outre positionnées selon la seconde direction Y en regard des premières électrodes 21, avec une dimension selon cette seconde direction Y inférieure à la largeur des premières électrodes 21.

Les troisièmes électrodes 23 sont reliées à la périphérie de la surface de détection 10 par des pistes de liaison 24 qui sont tracées sur la même seconde couche conductrice 41 que ces électrodes.

Chaque piste de liaison 24 est reliée, dans la surface de détection 10, à plusieurs troisièmes électrodes 23 successives. Dans le mode de réalisation présenté, chaque piste de liaison 24 est ainsi reliée à trois troisièmes électrodes 23 successives selon la seconde direction Y. Bien entendu, il s'agit d'un exemple non limitatif et en pratique chaque piste de liaison 24 peut être reliée à un nombre quelconque de troisièmes électrodes 23.

Les troisièmes électrodes 23 ainsi reliées à une piste de liaison 24 se comportent comme une électrode unique, ou macro-électrode, d'une dimension correspondant sensiblement à la surface couverte par l'ensemble des troisièmes électrodes 23 interconnectées.

Les pistes de liaisons 24 s'étendent pour l'essentiel selon la seconde direction Y. Elles sont placées parallèlement aux secondes électrodes 22, entre ces secondes électrodes 22 et les troisièmes électrodes 23. Dans le mode de réalisation présenté, la dimension des troisièmes électrodes 23 dans la seconde direction Y est en outre réduite en fonction du nombre de pistes de liaisons 24 issues d'autres troisièmes électrodes 23 qui les longent.

Ce mode de réalisation présente l'avantage de pouvoir être réalisé avec un panel à deux couches conductrices. Toutefois, les pistes de liaisons 24 sont exposées aux coupages capacitifs avec des objets d'intérêt, qui peuvent être sources de diaphonies. Cet effet est toutefois moins gênant que pour une structure d'électrodes purement matricielle classique car :
- les pistes de liaison 24 sont moins nombreuses, et surtout,
- pour qu'il y ait un effet perturbateur significatif, il faut que le couplage entre l'objet d'intérêt et les pistes de liaison 24 soit important, ce qui signifie que l'objet d'intérêt 15 est à proximité immédiate ou en contact avec la surface de détection 10. Et dans ce cas, l'objet d'intérêt est aussi détecté sans perturbations par les premières électrodes 21 et les secondes électrodes 22.

Dans le mode de réalisation présenté, chaque piste de liaison 24 issue de la surface de détection 10 est reliée directement à une électronique de détection capacitive matricielle 26.

De même que pour le mode de réalisation de la Fig. 2, les pistes de liaison 24 issues de troisièmes électrodes 23 adjacentes dans la première direction X (par exemple 3 colonnes adjacentes) peuvent être reliées électriquement ou interconnectées dans une zone en périphérie, ou zone périphérique 25 de la surface de détection, de sorte à réaliser une matrice de macro-électrodes dont le pas dans les deux directions X et Y est comparable. Il est également possible de n'interconnecter dans la zone périphérique 25 qu'une partie des pistes de liaison issues de colonnes adjacentes, de sorte à réaliser des macro-électrodes 1,2 de taille différente en fonction de leur position dans la surface de détection 10.

Suivant des variantes applicables notamment à tous les modes de réalisation précédemment décrits :
- Le dispositif d'interface tactile et sans contact selon l'invention peut comprendre des premières électrodes 21 et/ou des secondes électrodes 22 qui s'étendent depuis un bord de la surface de détection 10 dans cette surface de détection 10 avec une extension limitée, donc pas jusqu'au bord opposé. Le dispositif d'interface tactile et sans contact selon l'invention peut ainsi comprendre des premières électrodes 21 et/ou des secondes électrodes 22 qui s'étendent depuis un bord de la surface de détection 10 jusqu'au milieu de cette surface de détection. Dans ce cas, chaque ligne et/ou chaque colonne de la surface de détection 10 comprend deux premières électrodes 21 et/ou deux secondes électrodes 22 distinctes ;
- le dispositif d'interface tactile et sans contact selon l'invention peut comprendre des troisièmes électrodes 23 avec une dimension selon la seconde direction Y correspondant au recouvrement ou à l'étendue de plusieurs premières électrodes 21 successives ;
- Le dispositif d'interface tactile et sans contact selon l'invention peut comprendre une seule première électrode 21 s'étendant sur toute la surface sensible 10. Cette première électrode 21 peut être reliée à l'électronique de détection capacitive en lignes-colonnes 27 de la même manière que plusieurs premières électrodes 21. Bien entendu dans ce cas, la détection des objets d'intérêt 15 selon la seconde direction (Y) est effectuée uniquement avec des troisièmes électrodes.

On va maintenant décrire des modes de réalisation de moyens électroniques de détection capacitive destinés à être reliés aux premières, secondes et troisièmes électrodes capacitives pour permettre la détection et la localisation d'objets d'intérêts 15.

Dans les modes de réalisation précédemment décrits, ces moyens électroniques de détection capacitive comprennent :
- une électronique de détection capacitive en lignes-colonnes 27 destinée à être reliée aux premières électrodes 21 (ou le cas échéant à une première électrode 21) et aux secondes électrodes 22 ;
- une électronique de détection capacitive matricielle 26 destinée à être reliée aux troisièmes électrodes 23 par l'intermédiaire des pistes de liaison 24.

Bien entendu, l'électronique de détection capacitive en lignes-colonnes 27 et l'électronique de détection capacitive matricielle 26 peuvent être réalisées, dans la cadre de l'invention, sous la forme de deux modules électroniques distincts, ou sous la forme d'un module électronique unique. De même, elles peuvent comprendre des voies de mesure distinctes, et/ou des voies de mesures communes ou mutualisées.

Ces moyens électroniques de détection capacitive peuvent comprendre des composants et des modules d'électronique analogique et/ou des composants et des modules numériques, avec des microprocesseurs, ....

Les moyens électroniques de détection capacitive sont reliés en sortie à des moyens de calcul, par exemple de type ordinateur, microprocesseur, FPGA, ..., pour traiter les mesures, déterminer les positions et/ou les déplacements d'objets d'intérêts 15, et exploiter ces informations pour réaliser par exemple des fonctions de détection d'environnement, ou d'interface homme-machine.

Dans le mode de réalisation présenté :
- L'électronique de détection capacitive en lignes-colonnes 27 est agencée pour effectuer des mesures de capacités de couplage, en mode « mutual », entre les premières électrodes 21 utilisées comme électrodes d'excitation (ou le cas échéant la première électrode 21 utilisée comme électrode d'excitation) et les secondes électrodes 22 utilisées comme électrodes de mesure. La présence d'un objet d'intérêt 15 à proximité d'une intersection ou d'une zone de recouvrement entre une première électrode 21 et une seconde électrode 22 perturbe la capacité de couplage entre ces deux électrodes, ce qui permet de détecter sa présence ;
- L'électronique de détection capacitive matricielle 26 est agencée pour effectuer des mesures directes de capacité en mode « self ». Dans ce cas on mesure directement la capacité de couplage entre une électrode et les objets d'intérêts présents dans son voisinage.

En référence à la Fig. 6, on va maintenant décrire un mode de réalisation d'électronique capacitive pour effectuer des mesures directes de capacité en mode « self ».

Ce mode de réalisation met en œuvre une garde active.

Le schéma électronique mis en œuvre dans ce mode de réalisation est basé sur un amplificateur de charges 62 représenté sous la forme d'un amplificateur opérationnel 62 avec une capacité de contre réaction 64.

Il permet de mesurer la capacité entre un objet d'intérêt 15 globalement référencé ou relié à la masse générale du système 65 (c'est-à-dire la masse ou le potentiel de référence de l'électronique ou de l'appareil, qui peut aussi être une terre) et une électrode de mesure capacitive 68.

Cette électronique capacitive peut notamment être implémentée dans l'électronique de détection capacitive matricielle 26. Dans ce cas, l'électrode de mesure capacitive 68 correspond à un groupe de troisièmes électrodes 23 relié à une piste de liaison ou une macro-électrode 1, 2. La mesure de cette capacité permet de déduire par exemple une information de distance entre l'objet d'intérêt 15 et l'électrode de mesure 68.

L'électrode de mesure 68 est reliée à l'entrée (-) de l'amplificateur de charge 62.

L'entrée (+) de l'amplificateur de charge 62 est excitée par un oscillateur 67 qui délivre une tension alternative de référence 66, appelée également potentiel de garde 66. L'électrode de mesure 68 est ainsi polarisée sensiblement à cette même tension de référence 66.

La sortie de l'amplificateur de charge est reliée à un amplificateur différentiel 63 qui permet d'obtenir en sortie une tension représentative des capacités à l'entrée de l'amplificateur de charge 62, et ainsi produire des informations de localisation et/ou de distances d'objets d'intérêts 15 exploitables.

Le dispositif comprend également des éléments de garde 60 destinés à protéger les électrodes de mesure 68 et les éléments de liaison entre les électrodes 68 et l'électronique. Ces éléments de garde 60 sont polarisés au potentiel de garde 66 généré par l'oscillateur 67, qui est ainsi utilisée comme potentiel d'excitation pour générer une garde active approximativement au même potentiel que les électrodes de mesure 68.

Dans les modes de réalisation présentés, ces éléments de garde 60 comprennent notamment les premières électrodes 21 et les secondes électrodes 22, qui sont reliées au potentiel de garde 66 au moins pendant que des mesures sont effectuées avec les troisièmes électrodes 23. Les éléments de garde 60 comprennent également les troisièmes électrodes 23 qui ne sont pas mesurantes.

Le dispositif comprend également des moyens de scrutation ou des switchs 61 qui permettent de sélectionner ou configurer les électrodes 68. Ces switchs 61 sont agencés de telle sorte qu'une électrode 68 est :
- soit reliée à l'amplificateur de charge et pour effectuer des mesures, auquel cas elle est mesurante,
- soit reliée au potentiel de garde pour contribuer aux éléments de garde 60,
- soit reliée au potentiel de masse générale 65 (ou selon une solution alternative électriquement flottante, en circuit ouvert), pour ne pas perturber les mesures en lignes et colonnes avec les premières électrodes 21 et les secondes électrodes 22.

Dans ce mode de réalisation, l'électronique de détection capacitive avec l'amplificateur de charge 62 et l'amplificateur différentiel 63 sont globalement référencés à la masse générale 65.

Ce mode de réalisation a toutefois l'inconvénient de permettre la présence de capacités de fuite entre les électrodes 68 et/ou l'entrée de l'amplificateur de charge 62 et des éléments au potentiel de masse général 65.

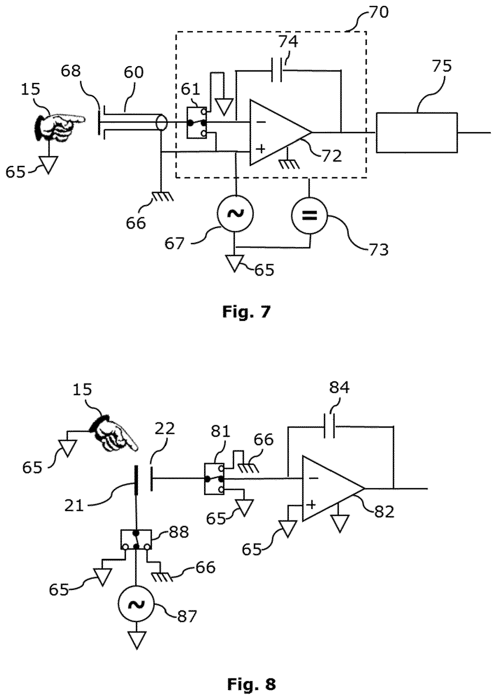

En référence à la Fig. 7, on va maintenant décrire un second mode de réalisation d'électronique capacitive pour effectuer des mesures directes de capacité en mode « self ».

Ce mode de réalisation met en œuvre une garde active et une électronique référencée au potentiel de garde.

Comme précédemment, Il permet également de mesurer la capacité entre un objet d'intérêt 15 référencé à la masse générale du système 65 et une électrode de mesure capacitive 68.

Cette électronique capacitive peut notamment être implémentée dans l'électronique de détection capacitive matricielle 26. Dans ce cas, l'électrode de mesure capacitive 68 correspond à un groupe de troisièmes électrodes 23 relié à une piste de liaison ou une macro-électrode 1, 2. Comme expliqué précédemment, la mesure de cette capacité permet de déduire par exemple la distance entre l'objet d'intérêt 15 et l'électrode de mesure 68.

Dans ce mode de réalisation, l'électronique comprend une partie dite « flottante » 70 globalement référencé à un potentiel de référence alternatif 66 (ou potentiel de garde) généré par un oscillateur 67. Ainsi, il ne peut pas apparaître de capacités de fuite, puisque tous les éléments, y compris les électrodes 68 et la partie sensible de l'électronique de détection, sont au même potentiel de garde. On peut ainsi obtenir de grandes sensibilités et détecter des objets d'intérêt 15 à des distances de plusieurs centimètres.

Ce type d'électronique de détection, dite « à référence flottante » ou « en pont flottant », est décrit en détail par exemple dans le document US 8,933,710. Aussi, pour des raisons de concision, seules les caractéristiques essentielles sont rappelées ici.

Comme précédemment, le schéma électronique mis en œuvre dans ce mode de réalisation est basé sur un amplificateur de charges 72, représenté sous la forme d'un amplificateur opérationnel 72 avec une capacité de contre réaction 74.

L'amplificateur de charge 72, comme toute la partie sensible de l'électronique de détection, est référencé au potentiel de garde 66 et fait donc partie de la partie flottante 70 de l'électronique.

Cette partie flottante 70 peut bien entendu comprendre d'autres moyens de traitement et de conditionnement du signal, y compris numériques ou à base de microprocesseur, également référencés au potentiel de garde 66. Ces moyens de traitement et de conditionnement permettent par exemple de calculer des informations de distance et de position à partir des mesures capacitives.

L'alimentation électrique de la partie flottante 70 est assurée par des moyens flottants de transfert d'alimentation 73, comprenant par exemple des convertisseurs DC/DC.

L'électronique flottante 70 est reliée en sortie à l'électronique de l'appareil référencée à la masse générale 65 par des éléments de liaisons 75 compatibles avec la différence de potentiels de référence. Ces éléments de liaisons 75 peuvent comprendre par exemple des amplificateurs différentiels ou des optocoupleurs. On obtient ainsi en sortie de ces éléments de liaison 75 des informations de localisation et/ou de distances d'objets d'intérêts exploitables.

Dans le mode de réalisation présenté, l'électrode de mesure 68 est reliée à l'entrée (-) de l'amplificateur de charge 72.

L'entrée (+) de l'amplificateur de charge 72 est excitée par l'oscillateur 67 qui délivre la tension alternative de référence 66, ou potentiel de garde 66. L'électrode de mesure 68 est ainsi polarisée sensiblement à cette même tension de référence 66.

Le dispositif comprend également des éléments de garde 60 destinés à protéger les électrodes de mesure 68 et les éléments de liaison entre les électrodes 68 et l'électronique. Ces éléments de garde 60 sont polarisés au potentiel de garde 66 généré par l'oscillateur 67, qui est donc aussi le potentiel de référence de l'électronique flottante 70.

Dans les modes de réalisation présentés, ces éléments de garde 60 comprennent notamment les premières électrodes 21 et les secondes électrodes 22, qui sont reliées au potentiel de garde 66 au moins pendant que des mesures sont effectuées avec les troisièmes électrodes 23. Les éléments de garde 60 comprennent également les troisièmes électrodes 23 qui ne sont pas mesurantes.

Le dispositif comprend également des moyens de scrutation ou des switchs 61 qui permettent de sélectionner ou configurer les électrodes 68. Ces switchs 61 sont agencés de telle sorte qu'une électrode 68 est :
- soit reliée à l'amplificateur de charge et pour effectuer des mesures, auquel cas elle est mesurante,
- soit reliée au potentiel de garde pour contribuer aux éléments de garde 60,
- soit reliée au potentiel de masse générale 65 (ou selon une solution alternative électriquement flottante, en circuit ouvert), pour ne pas perturber les mesures en lignes et colonnes avec les premières électrodes 21 et les secondes électrodes 22.

Dans les modes de réalisation présentés, l'électronique de détection capacitive matricielle 26 peut comprendre un ou plusieurs amplificateurs de charge reliés respectivement à une pluralité de groupes d'électrodes 23 (ou de macro-électrodes 1, 2) par des switchs 61. Dans ce cas, les mesures sont au moins en partie effectuées séquentiellement.

L'électronique de détection capacitive matricielle 26 peut comprendre également autant d'amplificateurs de charge que de groupes d'électrodes 23 (ou de macro-électrodes 1, 2). Cela permet d'effectuer toutes les mesures en parallèle. Dans ce cas, les switchs 61 peuvent être agencés de telle sorte qu'une électrode 68 est :
- soit reliée à l'amplificateur de charge et pour effectuer des mesures, auquel cas elle est mesurante,
- soit reliée au potentiel de masse générale 65 (ou selon une solution alternative électriquement flottante, en circuit ouvert), pour ne pas perturber les mesures en lignes et colonnes avec les premières électrodes 21 et les secondes électrodes 22.

En référence à la Fig. 8, on va maintenant décrire un mode de réalisation d'électronique capacitive pour effectuer des mesures de capacités de couplage en mode « mutual », tel qu'il peut être implémenté dans l'électronique de détection capacitive en lignes-colonnes 27.

Dans ce mode de réalisation, les premières électrodes 21 sont des électrodes d'excitation. Elles peuvent être polarisées à un potentiel d'excitation par une source d'excitation 87 pour activer les mesures sur la ligne correspondante, ou reliées à la masse générale 65 pour être désactivées. Elles sont contrôlées par des switchs d'excitation 88 qui sont agencés de sorte qu'une première électrode 21 est :
- soit reliée à la source d'excitation 87, auquel cas elle est active pour une mesure de capacité de couplage ;
- soit reliée à la masse générale 65 du système, auquel cas elle est inactive ;
- soit reliée au potentiel de garde 66 pour contribuer aux éléments de garde 60 lors des mesures avec les troisièmes électrodes 23.

Suivant un mode de réalisation, la source d'excitation 87 correspond à l'oscillateur 67 qui génère le potentiel de garde 66. Dans ce cas le potentiel d'excitation correspond au potentiel de garde 66, et les switchs d'excitation 88 peuvent être agencés de sorte qu'une première électrode 21 est :
- soit reliée au potentiel de garde 66 ;
- soit reliée à la masse générale 65 du système, auquel cas elle est inactive.

Les secondes électrodes 22, qui sont les électrodes de mesure, sont reliées respectivement, par l'intermédiaire de switchs de mesure 81, à un amplificateur de charge 82 avec une capacité de contre réaction 84.

Les switchs de mesure 81 sont agencés de sorte qu'une seconde électrode 22 est :
- soit reliée à l'amplificateur de charge 82, auquel cas elle est active pour une mesure de capacité de couplage,
- soit reliée à la masse générale 65 du système, auquel cas elle est inactive,
- soit reliée au potentiel de garde 66 pour contribuer aux éléments de garde 60 lors des mesures directes de capacité avec les troisièmes électrodes 23.

Dans ce mode de réalisation, l'électronique est reliée au potentiel de masse générale 65.

Les switchs d'excitation 88 et de mesure 81 permettent de sélectionner un couple de premières 21 et secondes électrodes 22 et ainsi de mesurer spécifiquement la capacité de couplage à l'intersection de ces premières et secondes électrodes. Lorsqu'un objet d'intérêt 15 est à proximité immédiate de cette intersection, il modifie le valeur de la capacité de couplage, ce qui permet de le détecter.

L'électronique de détection capacitive en lignes-colonnes 27 peut comprendre une pluralité d'amplificateurs de charges 82 pour effectuer des mesures en parallèles. Elle peut également comprendre autant d'amplificateurs de charge 82 que de secondes électrodes 22. Cela permet d'effectuer toutes les mesures en parallèle. Dans ce cas, les switchs de mesure 81 peuvent être agencés de telle sorte qu'une seconde électrode 22 est :
- soit reliée à l'amplificateur de charge pour effectuer des mesures de capacité de couplage, auquel cas elle est mesurante,
- soit reliée au potentiel de garde 65 pour contribuer aux éléments de garde 60 lors des mesures directes de capacité avec les troisièmes électrodes 23.

Suivant une variante de mode de réalisation, l'électronique de détection capacitive en lignes-colonnes 27 peut être agencée pour effectuer des mesures de capacités de couplage, en mode « mutual », entre les secondes électrodes 22 utilisées comme électrodes d'excitation et les premières électrodes 21 utilisées comme électrodes de mesure.

Suivant une variante de mode de réalisation, l'électronique de détection capacitive en lignes-colonnes 27 peut être agencée pour effectuer des mesures directes de capacité en mode « self » avec les premières électrodes capacitives 21 et les secondes électrodes capacitives 22. Dans ce cas, elle peut être implémentée en mettant en oeuvre :
- le schéma d'électronique capacitive de mesure directe de capacité en mode « self » avec une garde active décrit en relation avec la Fig. 6 ; ou
- le schéma d'électronique capacitive de mesure directe de capacité en mode « self » avec une garde active et une électronique référencée au potentiel de garde décrit en relation avec la Fig. 7.

Ce mode de réalisation peut être réalisé avec les toutes structures de panel et d'électrodes décrites précédemment en relation avec les Fig. 1 à Fig. 5 notamment.

Dans ce mode de réalisation de l'électronique de détection capacitive en lignes-colonnes 27 :
- Les premières électrodes 21 et les secondes électrodes 22 correspondent donc aux électrodes de mesure capacitive 68 des Fig. 6 et Fig. 7. Elles sont reliées à des amplificateurs de charge 62, 72, directement ou par l'intermédiaire de switchs 61 ;
- Les switchs 61 sont agencés de sorte à relier les électrodes de mesure 68, soit au potentiel de garde 66, soit à l'entrée de l'amplificateur de charge 62, 72, soit éventuellement à la masse 65.

Le dispositif peut être agencé de sorte à comprendre :
- Des amplificateurs de charge 62, 72 reliés uniquement, directement ou par l'intermédiaire de switchs, soit à des premières électrodes 21, soit à des secondes électrodes 22, soit des troisièmes électrodes 23 ;
- Des amplificateurs de charge 62, 72 reliés par l'intermédiaire de switchs à au moins deux sortes d'électrodes capacitives parmi les premières électrodes 21, les secondes électrodes 22 et les troisièmes électrodes 23.

L'électronique de détection capacitive en lignes-colonnes 27 et l'électronique de détection capacitive matricielle 26 peuvent être confondues ou distinctes.

Cette variante de mode de réalisation avec les premières électrodes capacitives 21 et les secondes électrodes capacitives 22 utilisées en mode « self » permet d'augmenter la portée de détection de ces premières électrodes capacitives 21 et ces secondes électrodes capacitives 22. Il présente toutefois l'inconvénient de permettre également l'apparition de mesures fantômes en présence de plusieurs objets d'intérêt 15. Il est à noter que les mesures des troisièmes électrodes 23 peuvent être utilisées pour rejeter certaines mesures fantômes.

On va maintenant décrire un procédé de mesure et de détection d'objets d'intérêt 15 selon l'invention.

Ce procédé peut être mis en œuvre avec l'un quelconque des modes de réalisation décrits précédemment.

Le procédé de mesure comprend une étape de mesure d'approche ou de survol en utilisant les troisièmes électrodes 23. Pour cela, les premières électrodes 21 et les secondes électrodes 22 sont polarisées au potentiel de garde 66 par, respectivement, les switchs d'excitation 88 et les switchs de mesure 81. Ainsi elles contribuent aux éléments de garde 60. Les troisièmes électrodes 23 sont interrogées séquentiellement ou en parallèle tel que décrit dans les modes de réalisation d'électronique en relation avec les Fig. 6 ou Fig. 7. On peut ainsi détecter et mesurer la position et la distance d'objets d'intérêt 15 dans un voisinage des troisièmes électrodes 23, y compris à des distances de plusieurs centimètres ou même plusieurs dizaines de centimètres.

Le procédé de mesure comprend également une étape de mesure de contact ou de « touches » en utilisant les premières électrodes 21 et les secondes électrodes 22. Pour cela, lorsque les mesures sont effectuées en mode « mutual » (mesure de capacités de couplage), les troisièmes électrodes 23 sont reliées au potentiel de masse 65 (ou configurées en mode flottant, déconnectées électriquement), par les switchs 61. Les mesures de capacités de couplage sont effectuées avec des couples de premières électrodes 21 et les secondes électrodes comme décrit dans le mode de réalisation d'électronique en relation avec la Fig. 8. On peut ainsi détecter et mesurer la position et la distance d'objets d'intérêt 15 à proximité immédiate ou en contact avec la surface de détection 10, avec une grande précision dans leur localisation. Lorsque les mesures sont effectuées en mode «self» (mesure directes de capacités), la ou les premières électrodes 21 et les secondes électrodes 22 sont reliées séquentiellement ou en parallèle à des amplificateurs de charge 62, 72, directement ou par l'intermédiaire de switchs 61, comme décrit en relation avec les Fig. 6 ou Fig. 7.

Suivant des modes d'implémentation, il est possible, par exemple :
- d'exécuter les étapes de mesures d'approche et de mesure de contact séquentiellement, de manière systématique ;
- d'exécuter l'étape de mesures d'approche, et, lorsque des objets d'intérêts sont détectés dans un voisinage, d'exécuter l'étape de mesure de contact,
- lorsque les mesures de contact avec les premières électrodes 21 et les secondes électrodes 22 sont exécutées en mode « self », d'exécuter les étapes de mesures d'approche et de mesure de contact simultanément, car toutes les électrodes sont au potentiel de garde 66.

Bien entendu, les mesures obtenues lors des étapes de mesures d'approche et des étapes de mesure de contact peuvent être combinées ou analysées conjointement dans une étape d'analyse pour améliorer la détection et la mesure de position des objets d'intérêts 15, et/ou rejeter des artéfacts ou des mauvaises mesures.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif d'interface capacitive, comprenant une surface de détection (10) avec :
- une ou des premières électrodes capacitives (21) s'étendant selon au moins une première direction (X),
- des secondes électrodes capacitives (22) disposées en regard de la ou des premières électrodes capacitives (21) et s'étendant selon une seconde direction (Y) différente de la première direction (X),
- des troisièmes électrodes capacitives (23) agencées selon une disposition matricielle entre les secondes électrodes capacitives (22) et en regard de la ou des premières électrodes capacitives (21),
- des pistes de liaison (24, 34) agencées dans la surface de détection (10) de sorte à relier électriquement une pluralité de troisièmes électrodes capacitives (23) voisines,
- une première couche conductrice à l'électricité (11) avec la ou les premières électrodes capacitives (21), et
- une seconde couche conductrice à l'électricité (12) avec les secondes électrodes capacitives (22) ;
**caractérisé en ce qu'**il comprend en outre :
- une troisième couche conductrice à l'électricité (13), placée entre la première couche conductrice à l'électricité (11) et la seconde couche conductrice à l'électricité (12), avec les troisièmes électrodes capacitives (23) et les pistes de liaison (24, 34).

2. Dispositif selon la revendication 1, **caractérisé en ce qu'**il comprend des pistes de liaison (24) avec une portion reliant au moins une troisième électrode capacitive (23) à un bord de la surface de détection (10) s'étendant essentiellement selon la seconde direction (Y).

3. Dispositif selon l'une quelconque des revendications précédentes, **caractérisé en ce qu'**il comprend des premières électrodes capacitives (21) avec une dimension selon la seconde direction (Y) supérieure à l'espace de séparation entre lesdites premières électrodes capacitives (21).

4. Dispositif selon l'une quelconque des revendications précédentes, **caractérisé en ce qu'**il comprend des troisièmes électrodes capacitives (23) avec une dimension selon la deuxième direction (Y) inférieure ou égale à la dimension de la ou des premières électrodes capacitives (21) selon ladite deuxième dimension (Y), et agencées respectivement en regard d'une première électrode capacitive (21).

5. Dispositif selon l'une quelconque des revendications précédentes, **caractérisé en ce qu'**il comprend des pistes de liaison (24, 34) au moins en partie disposées sous les secondes électrodes capacitives (22).

6. Dispositif selon l'une quelconque des revendications précédentes, **caractérisé en ce que** des pistes de liaison (24, 34) reliées respectivement à des troisièmes électrodes capacitives (23) voisines sont en outre reliées électriquement en périphérie ou à l'extérieur de la surface de détection (10).

7. Dispositif selon l'une quelconque des revendications précédentes, **caractérisé en ce qu'**il comprend en outre des moyens électroniques de détection capacitive (26, 27) avec au moins un amplificateur de charge (62, 72) permettant d'effectuer des mesures directes de capacité entre des objets d'intérêt (15) au voisinage ou en contact avec la surface de détection (10) et des groupes de troisièmes électrodes capacitives (23).

8. Dispositif selon la revendication 7, **caractérisé en ce que** les moyens électroniques de détection capacitive (26, 27) comprennent des moyens de scrutation (61) permettant de relier séquentiellement des groupes de troisièmes électrodes capacitives (23) à un amplificateur de charge (62, 72).

9. Dispositif selon l'une quelconque des revendications 7 ou 8, **caractérisé en ce que** les moyens électroniques de détection capacitive (26, 27) sont agencés de sorte à polariser la ou les premières électrodes capacitives (21) et les secondes électrodes capacitives (22) à des potentiels sensiblement identiques ou proportionnels à un potentiel de garde (66), au moins durant des phases de mesures directe de capacité avec les troisièmes électrodes capacitives (23).

10. Dispositif selon la revendication 9, dans lequel le potentiel de garde (66) comprend l'un des potentiels suivants :
- un potentiel alternatif ;
- un potentiel continu,
- un potentiel identique, sensiblement identique ou proportionnel à un potentiel de masse (65).

11. Dispositif selon l'une quelconque des revendications 7 à 10, **caractérisé en ce qu'**il comprend en outre des moyens électroniques de détection capacitive (26, 27) avec au moins un amplificateur de charge permettant d'effectuer des mesures directes de capacité entre des objets d'intérêt (15) au voisinage ou en contact avec la surface de détection (10) et, respectivement, une ou des premières électrodes capacitives (21) et des secondes électrodes capacitives (22).

12. Dispositif selon l'une quelconque des revendications 7 à 10, **caractérisé en ce qu'**il comprend en outre des moyens électroniques de détection capacitive (26, 27) permettant d'effectuer des mesures de variations de capacité de couplage entre une ou des premières électrodes capacitives (21) et des secondes électrodes capacitives (22), de sorte à détecter la présence d'objets d'intérêt au voisinage ou en contact avec la surface de détection (10).

13. Dispositif selon la revendication 12, **caractérisé en ce qu'**il comprend des moyens électroniques de détection capacitive (26, 27) agencés de sorte à polariser au moins une première (21), respectivement une seconde électrode capacitive (22) avec un potentiel d'excitation, et à effectuer une mesure de capacité de couplage sur au moins une seconde (22), respectivement une première électrode capacitive (21).

14. Dispositif selon l'une quelconque des revendications 12 ou 13, **caractérisé en ce que** les moyens de détection électroniques (26, 27) sont agencés de sorte à maintenir les troisièmes électrodes capacitives (23), au moins durant des phases de mesure de capacités de couplage, dans l'un des états suivants :
- polarisées à un potentiel continu ;
- polarisées à un potentiel sensiblement identique à un potentiel de masse (65) ;
- polarisées à un potentiel sensiblement identique au potentiel d'au moins une première électrode capacitive (21) ;
- polarisées à un potentiel sensiblement identique au potentiel d'au moins une seconde électrode capacitive (22) ;
- flottantes électriquement.

15. Appareil comprenant un dispositif d'interface capacitive selon l'une quelconque des revendications précédentes.

16. Appareil selon la revendication 15, **caractérisé en ce qu'**il comprend un dispositif d'interface capacitive superposé ou intégré à un dispositif d'affichage.

## Patentansprüche

1. Kapazitive Schnittstellenvorrichtung, eine Erfassungsoberfläche (10) umfassend, mit:
- einer oder ersten kapazitiven Elektroden (21), die sich in mindestens eine Richtung (X) erstrecken,
- zweiten kapazitiven Elektroden (22), die gegenüber der oder den ersten kapazitiven Elektroden (21) gelagert sind und sich in eine zweite Richtung (Y) erstrecken, die nicht gleich der ersten Richtung (X) ist,
- dritten kapazitiven Elektroden (23), die in einer Matrizenanordnung zwischen den zweiten kapazitiven Elektroden (22) und gegenüber der oder den ersten kapazitiven Elektroden (21) angeordnet sind,
- Verbindungsbahnen (24, 34), die in der Erfassungsoberfläche (10) derart angeordnet sind, dass sie eine Vielzahl von benachbarten dritten kapazitiven Elektroden (23) elektrisch verbinden,
- einer ersten elektrisch leitenden Schicht (11) mit der oder den ersten kapazitiven Elektrode(n) (21) und
- einer zweiten elektrisch leitenden Schicht (12) mit den zweiten kapazitiven Elektroden (22);
**dadurch gekennzeichnet, dass** sie außerdem umfasst:
- eine dritte, zwischen der ersten elektrisch leitenden Schicht (11) und der zweiten elektrisch leitenden Schicht (12) liegende, elektrisch leitende Schicht (13) mit den dritten kapazitiven Elektroden (23) und den Verbindungsbahnen (24, 34).

2. Vorrichtung nach Anspruch 1, **dadurch gekennzeichnet, dass** sie Verbindungsbahnen (24) umfasst, von denen ein Abschnitt mindestens eine dritte kapazitive Elektrode (23) mit einem Rand der Erfassungsoberfläche (10) verbindet, der sich im Wesentlichen in die zweite Richtung (Y) erstreckt.

3. Vorrichtung nach einem der vorhergehenden Ansprüche, **dadurch gekennzeichnet, dass** sie erste kapazitive Elektroden (21) umfasst, die eine Abmessung in die zweite Richtung (Y) aufweisen, welche größer als der Trennabstand zwischen den ersten kapazitiven Elektroden (21) ist.

4. Vorrichtung nach einem der vorhergehenden Ansprüche, **dadurch gekennzeichnet, dass** sie dritte kapazitive Elektroden (23) umfasst, die eine Abmessung in die zweite Richtung (Y) aufweisen, welche kleiner oder gleich der Abmessung der ersten kapazitiven Elektrode oder Elektroden (21) in die zweite Richtung (Y) ist, und die jeweils gegenüber einer ersten kapazitiven Elektrode (21) angeordnet sind.

5. Vorrichtung nach einem der vorhergehenden Ansprüche, **dadurch gekennzeichnet, dass** sie Verbindungsbahnen (24, 34) umfasst, die zumindest zum Teil unter den zweiten kapazitiven Elektroden (22) gelagert sind.

6. Vorrichtung nach einem der vorhergehenden Ansprüche, **dadurch gekennzeichnet, dass** Verbindungsbahnen (24, 34), die jeweils mit benachbarten dritten kapazitiven Elektroden (23) verbunden sind, außerdem am Rand oder außerhalb der Erfassungsoberfläche (10) elektrisch verbunden sind.

7. Vorrichtung nach einem der vorhergehenden Ansprüche, **dadurch gekennzeichnet, dass** sie außerdem elektronische Mittel zur kapazitiven Erfassung (26, 27) mit mindestens einem Ladungsverstärker (62, 72) umfasst, womit direkte Kapazitätsmessungen zwischen zu untersuchenden Objekten (15) in der Nähe oder in Kontakt mit der Erfassungsoberfläche (10) und Gruppen der dritten kapazitiven Elektroden (23) durchführbar sind.

8. Vorrichtung nach Anspruch 7, **dadurch gekennzeichnet, dass** die elektronischen Mittel zur kapazitiven Erfassung (26, 27) Abtastmittel (61) umfassen, mittels derer Gruppen dritter kapazitiven Elektroden (23) sequentiell mit einem Ladungsverstärker (62, 72) verbunden werden.

9. Vorrichtung nach einem der Ansprüche 7 oder 8, **dadurch gekennzeichnet, dass** die elektronischen Mittel zur kapazitiven Erfassung (26, 27) derart angeordnet sind, dass sie wenigstens während Phasen der direkten Kapazitätsmessung mittels der dritten kapazitiven Elektroden (23) die erste(n) kapazitive(n) Elektrode(n) (21) und die zweiten kapazitiven Elektroden (22) mit Potentialen polarisieren, welche im Wesentlichen identisch mit oder proportional zu einem Überwachungspotential (66) sind.

10. Vorrichtung nach Anspruch 9, wobei das Überwachungspotential (66) eines der folgenden Potentiale umfasst:
- ein Wechselstrompotential
- ein Gleichstrompotential
- ein Potential, das identisch mit, im Wesentlichen identisch mit oder proportional zu einem Massepotential (65) ist.

11. Vorrichtung nach einem der Ansprüche 7 - 10, **dadurch gekennzeichnet, dass** sie außerdem elektronische Mittel zur kapazitiven Erfassung (26, 27) mit mindestens einem Ladungsverstärker umfasst, womit direkte Kapazitätsmessungen zwischen zu untersuchenden Objekten (15) in der Nähe oder in Kontakt mit der Erfassungsoberfläche (10) und jeweils einer oder ersten kapazitiven Elektroden (21) und zweiten kapazitiven Elektroden (22) durchführbar sind.

12. Vorrichtung nach einem der Ansprüche 7 - 10, **dadurch gekennzeichnet, dass** sie außerdem elektronische Mittel zur kapazitiven Erfassung (26, 27) umfasst, die die Durchführung von Schwankungsmessungen der Koppelkapazität zwischen einer oder ersten kapazitiven Elektroden (21) und zweiten kapazitiven Elektroden (22) ermöglichen, sodass vorliegende, zu untersuchende Objekte in der Nähe oder in Kontakt mit der Erfassungsoberfläche (10) erfasst werden.

13. Vorrichtung nach Anspruch 12, **dadurch gekennzeichnet, dass** sie elektronische Mittel zur kapazitiven Erfassung (26, 27) umfasst, die derart angeordnet sind, dass sie mindestens eine erste (21) beziehungsweise eine zweite kapazitive Elektrode (22) mit einem Anregungspotential polarisieren und sie die Koppelkapazität auf mindestens einer zweiten (22) beziehungsweise einer ersten kapazitiven Elektrode (21) messen.

14. Vorrichtung nach Anspruch 12 oder 13, **dadurch gekennzeichnet, dass** die elektronischen Mittel zur kapazitiven Erfassung (26, 27) derart angeordnet sind, dass sie die dritten kapazitiven Elektroden (23) zumindest während Phasen der Messung der Koppelkapazitäten in einem der folgenden Zustände halten:
- polarisiert mit einem Gleichstrompotential;
- polarisiert mit einem Potential, das im Wesentlichen gleich einem Massepotential (65) ist;
- polarisiert mit einem Potential, das im Wesentlichen gleich dem Potential mindestens einer ersten kapazitiven Elektrode (21) ist;
- polarisiert mit einem Potential, das im Wesentlichen gleich dem Potential mindestens einer zweiten kapazitiven Elektrode (22) ist;
- elektrisch schwebend.

15. Einrichtung, die eine kapazitive Schnittstellenvorrichtung nach einem der vorhergehenden Ansprüche umfasst.

16. Einrichtung nach Anspruch 15, **dadurch gekennzeichnet, dass** sie eine kapazitive Schnittstellenvorrichtung umfasst, die auf eine Anzeigevorrichtung aufgesetzt oder darin integriert ist.

## Claims

1. A capacitive interface device comprising a detection surface (10) with:
- one or more first capacitive electrodes (21) extending at least in a first direction (X),
- second capacitive electrodes (22) arranged facing the first capacitive electrode or electrodes (21) and extending in a second direction (Y) different from the first direction (X),
- third capacitive electrodes (23) arranged in a matrix between the second capacitive electrode (22) and facing the first capacitive electrode or electrodes (21), and
- linking tracks (24, 34) arranged in the detection surface (10) so as to electrically connect a plurality of adjacent third capacitive electrodes (23);
- a first electrically conductive layer (11) with the first capacitive electrode or electrodes (21), and
- a second electrically conductive layer (12) with the second capacitive electrodes (22)
**characterized in that** it comprises:
- a third electrically conductive layer (13), arranged between the first electrically conductive layer (11) and the second electrically conductive layer (12), with the third capacitive electrodes (23) and the linking tracks (24, 34).

2. The device according to claim 1, **characterized in that** it comprises linking tracks (24) with a portion connecting at least a third capacitive electrode (23) at an edge of the detection surface (10) extending essentially in the second direction (Y).

3. The device according to any one of the preceding claims, **characterized in that** it comprises first capacitive electrodes (21) with a dimension in the second direction (Y) that is greater than the separation space between said first capacitive electrodes (21).

4. The device according to any one of the preceding claims, **characterized in that** it comprises third capacitive electrodes (23) with a dimension in the second direction (Y) less than or equal to the dimension of the first capacitive electrode or electrodes (21) in said second direction (Y), and arranged respectively facing a first capacitive electrode (21).

5. The device according to any one of the preceding claims, **characterized in that** it comprises linking tracks (24,34) at least partly arranged under the second capacitive electrodes (22).

6. The device according to any one of the preceding claims, **characterized in that** the linking tracks (24, 34) connected respectively to adjacent third capacitive electrodes (23) are also electrically connected (or interconnected) at the periphery or outside the detection surface (10).

7. The device according to any one of the preceding claims, **characterized in that** it also comprises electronic capacitive detection means (26, 27) with at least one charge amplifier (62,72) making it possible to carry out direct measurements of capacitance between objects of interest (15) in the vicinity of or in contact with the detection surface (10) and groups of third capacitive electrodes (23).

8. The device according to claim 7, **characterized in that** the electronic capacitive detection means (26,27) comprise polling means (61) making it possible to sequentially connect groups of third capacitive electrodes (23) to a charge amplifier (62,72).

9. The device according to any one of claims 7 or 8, **characterized in that** the electronic capacitive detection means (26,27) are arranged so as to polarize the first capacitive electrode or electrodes (21) and the second capacitive electrodes (22) at potentials substantially identical or proportional to a guard potential (66), at least during phases of direct measurements of capacitance with the third capacitive electrodes (23).

10. The device according to claim 9, in which the guard potential (66) can comprise one of the following potentials:
- an alternating potential;
- a direct current potential;
- a potential identical, substantially identical or proportional to a ground potential (65).

11. The device according to any one of claims 7 to 10, **characterized in that** it also comprises electronic capacitive detection means (26, 27) with at least one charge amplifier making it possible to carry out direct measurements of capacitance between objects of interest (15) in the vicinity of or in contact with the detection surface (10) and, respectively, one or more capacitive electrodes (21) and second capacitive electrodes (22).

12. The device according to any one of claims 7 to 10, **characterized in that** it also comprises electronic capacitive detection means (26, 27) making it possible to carry out measurements of variations of coupling capacitance between one or more first capacitive electrodes (21) and second capacitive electrodes (22), in order to detect the presence of objects of interest in the vicinity of or in contact with the detection surface (10).

13. The device according to claim 12, **characterized in that** it comprises electronic capacitive detection means (26, 27) arranged so as to polarize at least a first (21), respectively a second (22) capacitive electrode with an excitation potential, and to carry out a measurement of coupling capacitance on at least a second (22), respectively a first (21) capacitive electrode.

14. The device according to any one of claims 12 or 13, **characterized in that** the electronic detection means (26,27) are arranged so as to maintain the third capacitive electrodes (23), at least during phases of measurement of coupling capacitance, in one of the following states:
- polarized at a direct current potential;
- polarized at a potential substantially identical to a ground potential (65);
- polarized at a potential substantially identical to the potential of at least one first capacitive electrode (21);
- polarized at a potential substantially identical to the potential of at least one second capacitive electrode (22);
- electrically floating.

15. The device comprising a capacitive interface device according to any one of the preceding claims.

16. The device according to claim 15, **characterized in that** it comprises a capacitive interface device superimposed on or integrated with a display device.
